# EUROPEAN PATENT APPLICATION

(11) **EP 0 700 102 A1**
(43) Date of publication of application: **06.03.1996**
(21) Application number: 95305984.7
(22) Date of filing: 24.08.1995
(51) Int. Cl.: H01L 31/18

(54) **Method for making opto-electronic conversion semiconductor device**

(30) Priority: 24.08.1994 JP 199889/94; 10.07.1995 JP 173810/95; 09.08.1995 JP 203601/95
(71) Applicant: SEIKO INSTRUMENTS INC., Chiba-shi, Chiba 261 (JP)
(72) Inventor: Satoh, Keiji, Seiko Instruments Inc., Chiba-shi, Chiba (JP); Saitoh, Yutaka, Seiko Instruments Inc., Chiba-shi, Chiba (JP); Yamanaka, Junko, Seiko Instruments Inc., Chiba-shi, Chiba (JP); Akamine, Tadao, Seiko Instruments Inc., Chiba-shi, Chiba (JP); Inoue, Masahiro, Seiko Instruments Inc., Chiba-shi, Chiba (JP)
(74) Representative: Sturt, Clifford Mark

(57) **Abstract**

An opto-electronic conversion semiconductor device having a deep depletion layer (11) which is not substantially influenced by process conditions. In one embodiment P⁺ type impurity region (2) is formed by ion-implanting BF₂ at an implantation energy of 80 keV and at a dose of 1 x 10¹⁵ atoms/cm into the surface of a silicon N⁻ semiconductor substrate (1) having a substrate resistance in a range of from 10 to 20 kΩ and a thickness of 500µm, and annealing the resulting structure thereafter at 950°C.

## Description

The present invention relates to an opto-electronic conversion semiconductor device and a process for fabricating the same.

An opto-electronic conversion semiconductor device refers to a device for use in measuring not only light in a wavelength region of from 100 nm to 1,200 nm but also X-rays, radiations and charged particles.

In general, it refers to semiconductor devices denoted as, for example, photodiodes, PIN diodes, avalanche photo diodes, photodiode arrays, photosensors, microstrip sensors, double microstrip sensors, radiation sensors, semiconductor image sensor devices and semiconductor image pickup devices.

The present invention relates to a constitution for realising an improvement in the performance of the aforementioned semiconductor devices, and to a fabrication process for implementing the same.

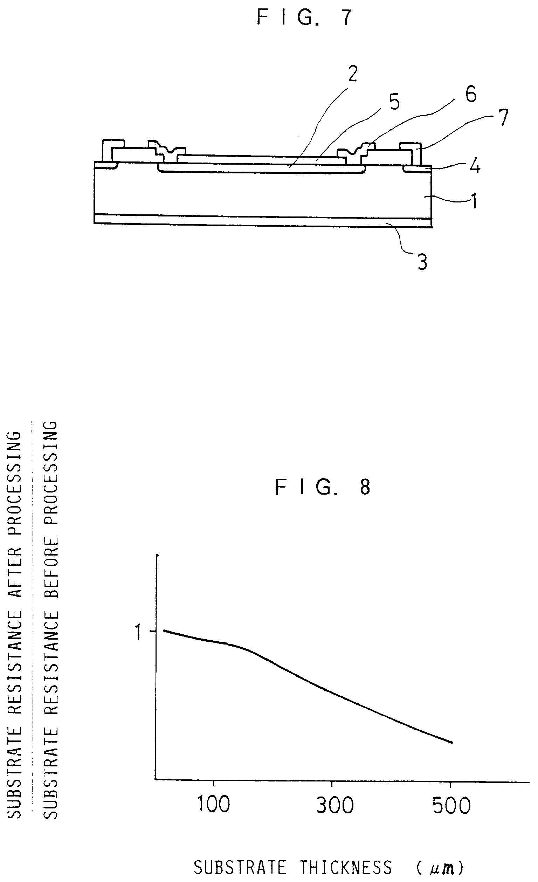

Conventionally, as shown in a schematic cross sectional view of Fig. 7, a type of a semiconductor for use in the field above comprises a P+ type impurity region 2 in an N⁻ type semiconductor substrate 1.

More specifically, as shown in the figure, it is a semiconductor device shown as a PIN diode; by taking the plane on which the P⁺ type impurity region 2 is present as the surface, an N⁺ type impurity region 3, which has a higher N-type concentration as compared with that of the substrate, is provided on the back of the substrate to form a PN junction comprising PN P⁺-N⁻N⁺.

A N⁻ type semiconductor substrate 1 containing impurities at a concentration in a range from 1 x 10¹ atms/cm³ to 1 x 10¹³ atms/cm³ (hereinafter, the unit "atms/cm³" is omitted when "concentration is referred to and "1 x 10¹ " is expressed as "1E12") is denoted as an intrinsic semiconductor, and the first letter of "intrinsic" stands for the "i" in PIN.

The symbols such as N⁻, N⁺, and P⁺ as referred herein signify that the concentration of the impurity for the respective conductive type is lower in case "-" is attached to the conductive type, and that is higher in case "+" is attached.

The i layer has a lower impurity concentration, and it has a thickness in the range from several tens to several thousands of µm. Such devices are widely used; the energy of light or radiation can be measured over a wide range because the elongation of the depletion layer is large in case a reserved bias is applied to the PN junction, and the device is suitable for a high speed response because a relatively large bias can be applied at a small junction capacitance.

The current attributed to the electron hole pairs which are generated in the depletion layer by the incident light or radiation principally contributes as the signal.

For instance, in case of providing an incidence from the P⁺ type impurity region side, and if the energy is as high as to yield a wavelength of 500 nm or shorter, the P⁺ type impurity region mostly absorbs the incident light, but it does not contribute to the generation of a signal current and hinders the transmission of the incident light to the depletion layer. Accordingly, this thickness is found problematic. Consequently, the P+ type impurity region is as shallow as possible.

From the viewpoint of minimising capacitance, the depletion layer is preferably as long as possible. For a detector for X-rays to be used in the field of high energy physics and astrophysics, the thickness (depth) of the depletion layer is preferably as thick (deep) as possible, particularly, 200 µm or more, and the depletion layer is preferably saturated. In other words, the depletion layer is deep, and it preferably saturates at a low voltage. However, particularly in this case, the resistivity of the substrate must be increased to a high level of 1 kΩ · cm or higher.

As described in the foregoing, opto-electric conversion semiconductor devices known heretofore have used high resistivity silicon substrate containing impurities at a low concentration. Accordingly, it has been found that the resistivity of the substrate changes depending on the process conditions, and that it is difficult to deeply extend the depletion layer. Particularly, the substrate resistivity lowers with increasing thickness of the substrate.

According to one aspect of the present invention, there is provided a method of making an opto-electronic conversion semiconductor device, the method characterised by effecting ion implantation using BF₂ at a dose less than 1 x 10¹⁵ atoms/cm on the surface of an N-type semiconductor substrate, and forming a P-type impurity region on the surface of said N-type semiconductor substrate.

The following characterising features of the present invention may individually or in any combination overcome or reduce the aforementioned problems.

According to a first feature, in case of forming a P-type impurity region by means of ion implantation, BF is implanted at a dose of 1 x 10¹⁵ atoms/cm or lower.

According to a second feature, in case of forming a P-type impurity region by means of ion implantation, BF is implanted at an implantation energy of 80 keV or lower.

According to a third feature, in case of forming a P-type impurity region by means of ion implantation, the annealing is effected at a temperature of 900°C or higher after BF is implanted.

According to a fourth feature, the process to be effected in an oxidizing atmosphere is performed at 950°C or lower.

According to a fifth feature, heat treatment in a non-oxidizing atmosphere at a temperature of 950° C or higher is effected before the step of forming a P-type impurity region.

According to a sixth feature, in the step of forming a P-type impurity region, BF₂ is ion-implanted at a dose of 1 x 10¹⁵ atoms/cm or lower after forming a P-type impurity region by means of thermal diffusion process.

According to a seventh feature, as the step of forming a P-type impurity region, the natural oxide film is removed from the surface of the semiconductor substrate to expose a chemically active surface, a gaseous compound containing boron is supplied to the active surface to form a layer of at least one selected from the group consisting of elemental boron and boron compounds, and solid phase diffusion and activation of impurities are effected by using said layer of at least one selected from the group consisting of elemental boron and boron compounds as an impurity diffusion source.

According to an eighth feature, the thickness of the substrate is controlled to 200µm or more.

According to a ninth feature, in the step of forming a P-type impurity region by means of BF₂ ion-implantation, the conditions of ion implantation are varied within a single substrate to change the resistivity of the substrate region surrounding the impurity region from that of the impurity region.

By effecting the first to the eighth features above, the drop in substrate resistivity for a thick semiconductor substrate having a large substrate resistivity can be prevented from occurring, or a desired resistivity can be attained.

By employing the ninth feature above, a PN junction or an element comprising a depletion layer differing in elongation can be fabricated.

For a better understanding of the invention embodiments will now be described by way of example, with reference to the accompanying drawings, in which:
Fig. 1A-1C are schematic cross sectional view showing the fabrication process steps of a P⁺ type impurity region of a semiconductor device according to an embodiment of the present invention;
Fig. 2 is a characteristic curve which relates a substrate resistance to an annealing temperature;
Fig. 3 is a characteristic curve which relates a substrate resistance to an annealing temperature;
Fig. 4 is a characteristic curve which relates a substrate resistance to an annealing temperature;
Fig. 5 is a characteristic curve which relates a substrate resistance to a thermal treatment temperature before ion implantation;
Figs. 6A-6D are schematic cross sectional views showing the fabrication process steps of a P⁺ type impurity region of another semiconductor device according to an embodiment of the present invention;
Fig. 7 is a schematic cross sectional view showing a PIN photodiode;
Fig. 8 is a diagram showing a relation between a substrate thickness and a change in substrate resistance before and after processing;
Fig. 9 is a diagram showing a change in substrate resistance before and after processing;
Fig. 10 is a schematic cross sectional view of an example according to the present invention; and
Fig. 11 is a diagram showing a change in substrate resistance before and after processing.

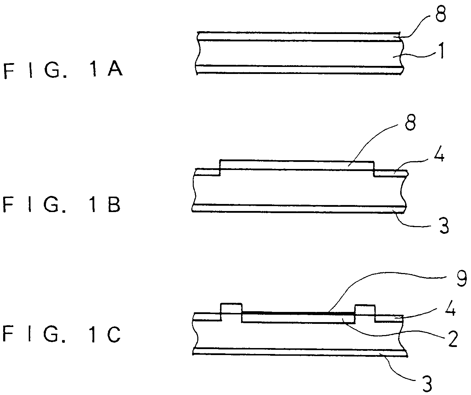

Figs. 1A to 1C are diagrams showing schematic cross sectional views for the steps for forming an impurity region of a semiconductor device according to an embodiment of the present invention.

First, referring to Fig. 1A, a first oxide film 8 is formed on the surface of an N⁻ semiconductor substrate 1 made from a high resistivity silicon by effecting thermal oxidation at 1,000°C in water vapour, and then, as shown in Fig. 1B, the oxide film is removed from predetermined portions to form an N⁺ type impurity region 4 and an N⁺ type impurity region 3 on the back.

The N⁺ type impurity region is formed by means of thermal diffusion of P, which comprises pre-deposition using POCl₃, followed by annealing (driving in) in an oxidizing atmosphere.

Then, a P⁺ type impurity region 2 is formed on a predetermined region.

More specifically, as shown in Fig. 1C, a thin SiO₂ film 9 from 150 to 250Å in thickness is formed by oxidation in oxygen at 920°C, BF₂ is introduced by ion implantation, and annealing is effected in N₂ atmosphere to form a P⁺ type impurity region.

For the formation of a shallower impurity region, for the reduction of residual damage, and particularly for a stable lowering of leak current, the ion implantation is effected preferably by using BF₂.

Thus is obtained a PIN diode as shown in Fig. 7.

An SiO₂ film 5 is formed just over the P⁺ type impurity region. The SiO₂ film is formed at a thickness which most reduces reflection. That is, the film also functions as a anti-reflection film, and is fabricated by means of chemical vapour deposition using SiH₄ and N₂O.

The anode electrode 6 and the cathode electrode 7 are formed from Al-1%Si by means of by sputtering and patterning, followed by alloying.

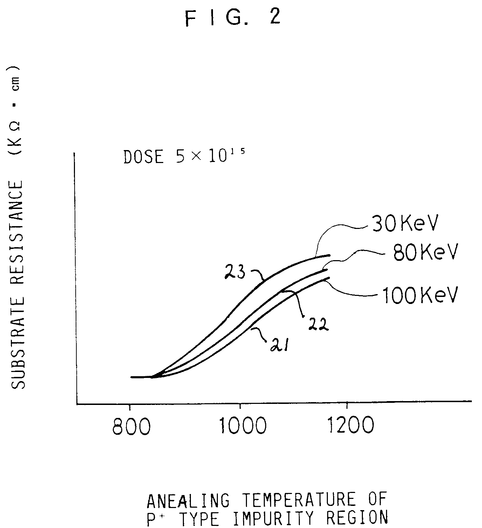

Fig. 2 shows characteristic curves each illustrating a relation between the substrate resistance and the annealing temperature in case of effecting ion implantation of BF₂ at a dose of 5 x 10¹⁵ atoms/cm under differing ion implantation conditions. Annealing temperature characteristic curves 21, 22 and 23 are each obtained at an implantation energy of 100 keV, 80 keV, and 30 keV, respectively.

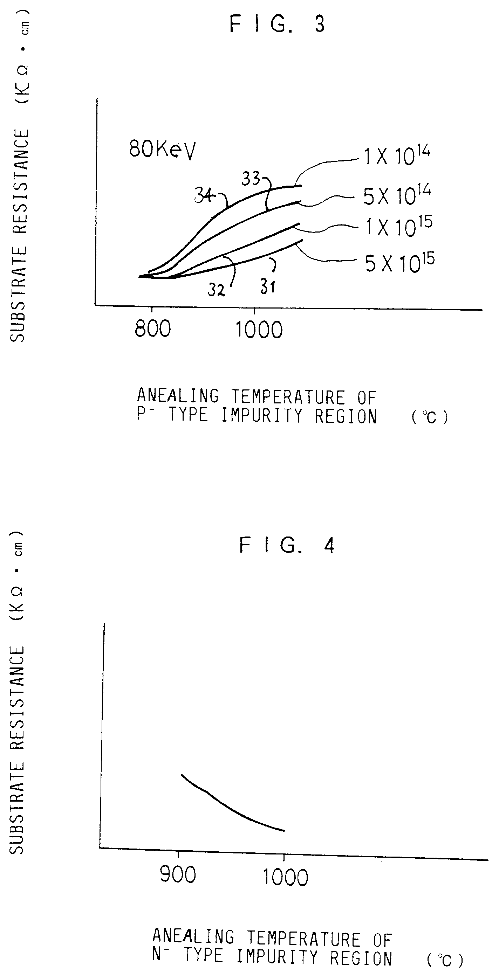

Fig. 3 shows characteristic curves each illustrating a relation between the substrate resistance and the annealing temperature in case of effecting ion implantation of BF₂ at an ion implantation energy of 80 keV under differing BF⁺ ion implantation conditions. Annealing temperature characteristic curves 31, 32, 33 and 34 are each obtained at a dose of 5 x 10¹⁵ atoms/cm, 1 x 10¹⁵ atoms/cm, 5 x 10¹⁴ atoms/cm, and 1 x 10¹⁴ atoms/cm, respectively.

The substrate resistance increases with lowering dose, increasing annealing temperature, and decreasing energy of ion implantation. This tendency is particularly distinguished for a dose of 1 x 10¹⁵ atoms/cm or lower, an annealing temperature of 900°C or higher, and an ion implantation energy of 80 kEV or lower.

In the foregoing, the annealing temperature during the formation of the N⁺ type impurity region is 950°C, the substrate resistance before the processing is in a range of from 10 to 20 kΩ and the substrate thickness is 500µm.

Fig. 4 is a characteristic curve showing the relation between the substrate resistance and the annealing temperature with changing annealing temperature in case of forming an N⁺ type impurity region by effecting implantation of BF₂ at an implantation energy of 80 keV, a dose of 5 x 10¹⁵ atoms/cm.

It can be seen that the substrate resistance is higher for a lower annealing temperature, and this tendency becomes distinct at a temperature not higher than 950°C.

In case of effecting the formation of the first oxide film in water vapour at 950°C by thermal oxidation and CVD, as compared with an oxide film of the same thickness prepared by thermal oxidation at 1000°C, one having a higher substrate resistance can be obtained by effecting both thermal oxidation and CVD.

As described above, a high temperature thermal treatment in an oxidizing atmosphere tends to lower the substrate resistance, and a high temperature thermal treatment in a non-oxidizing atmosphere increases the substrate resistance.

Accordingly, thermal treatment in nitrogen atmosphere is effected before performing ion implantation.

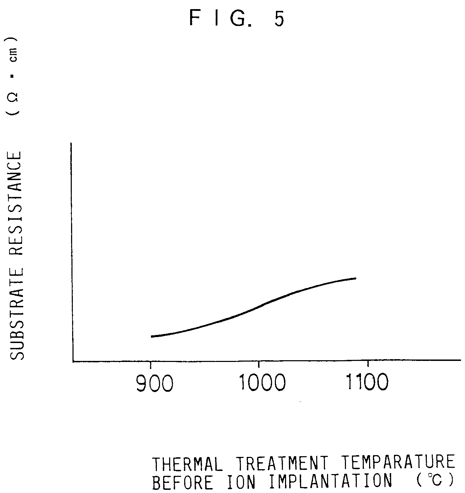

Fig. 5 shows a characteristic curve showing the relation between the substrate resistance and the thermal treatment temperature.

The substrate resistance increases with elevating temperature of heat treatment in a nitrogen atmosphere, and this tendency is distinct at temperatures of 950°C or higher.

A similar effect is obtained by effecting the thermal treatment before forming an N⁺ type impurity region.

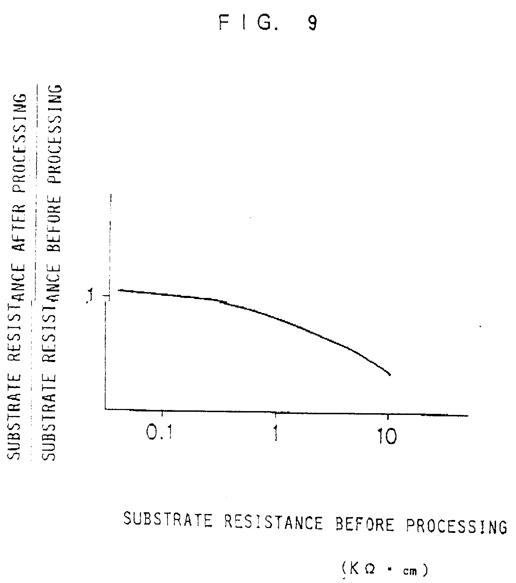

Fig. 9 shows the change in resistance of a substrate 350µm in thickness in case processing is performed by means of ion implantation effected at an ion implantation energy of 100 keV and a dose of 5 x 10¹⁵ atoms/cm, and annealing at 950°C. It can be seen therefrom that the substrate resistance greatly drops after processing a substrate having a substrate resistance of 1 kΩ or higher. The present invention is particularly effective for cases in which substrate resistance is 1 kΩ or higher.

Fig. 8 shows a relation between the substrate thickness and the change in substrate resistance before and after processing the substrate by effecting ion implantation of BF₂ at 100 keV and at a dose of 5 x 10¹⁵ atoms/cm and annealing at 950°C. It can be seen that the substrate resistance greatly drops after the process in substrates 200µm or less in thickness. The present invention is also effective in such cases; an increase in the annealing temperature or a decrease in the energy of ion implantation or the dose is necessary to maintain the same resistance with increasing thickness of substrate from 350µm to 500µm, but particularly effective for maintaining the same resistance is the control of dose and annealing temperature.

Thermal diffusion method is also usable for forming a P⁺ type impurity region.

In particular, a shallow and a damage-less P⁺ type impurity region can be obtained by a method to be described below.

That is, the process comprises a step of exposing a chemically active surface by removing a natural oxide film from the surface of a semiconductor substrate; a step of forming a boron- or a boron compound-diffused layer on the active surface by supplying a gaseous compound containing boron; and a step of solid phase diffusion and impurity activation using the layer as an impurity diffusion source.

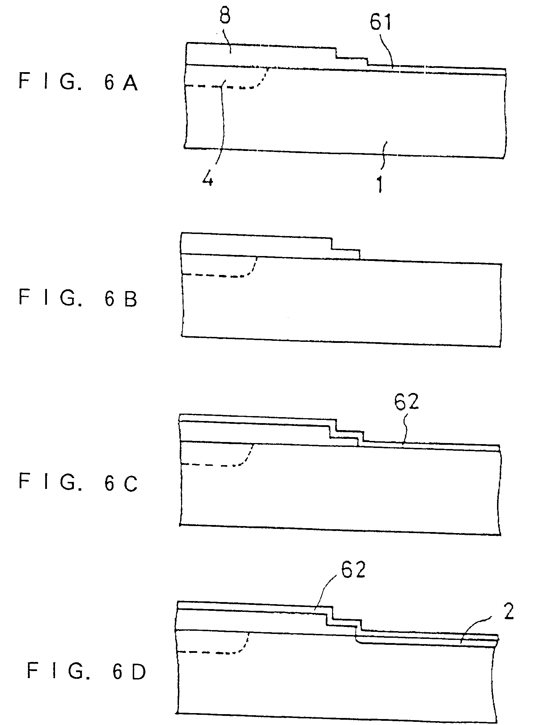

Figs. 6A to 6D are diagrams showing schematically drawn cross sectional views of the structure obtained in the steps of forming a P⁺ type impurity region according to the present invention.

An N⁻ type semiconductor substrate 1 is set at the central portion of a vacuum chamber the background pressure thereof is lowered to 10⁻⁴ Pa or lower, and gaseous hydrogen is introduced therein for a predetermined duration of time at a substrate temperature of, for instance, 850°C, under a condition as such that the pressure inside the chamber be 1.3 x 10⁻ Pa. In this manner, the natural oxide film 61 on the N⁻ type semiconductor substrate 1 can be removed to expose an active surface of silicon (Fig. 6B).

A compound gas containing boron, such as gaseous B₂H₆, is introduced to the active surface to form a boron or a boron silicide film.

The substrate temperature is set at, for instance, 825°C, and on reaching the set temperature, a compound containing boron, i.e., diborane (B₂H₆), is introduced for a predetermined duration of time under such a condition that the pressure inside the chamber is 1.3 x 10⁻ Pa. Thus is formed a boron or a boron silicide film 62 (Fig. 6C).

In this step, a highly controlled doping can be effected by introducing gas under controlled conditions such that the product obtained by multiplying the pressure of introducing B₂H₆ by the duration of introducing the gas is 4.2 Pa·sec or higher.

In case the substrate temperature is in a range of 300 to 700°C upon introducing B₂H₆, a film of boron can be obtained, and if the substrate temperature is 700°C or higher, a film of boron silicide can be obtained.

When forming a boron film or a boron silicide film of 10 nm or thicker, the diffusion becomes such which yields a constant surface concentration which depends on the limit of solid solution at a given temperature. Thus, a uniform and a highly controllable doping can be effected.

The deposition of boron film occurs by thermal CVD, but the formation of boron silicide occurs by the reaction of boron inside gaseous B₂H₆ with Si. Accordingly, this differs from an ordinary CVD process.

A boron silicide film is more stable than a boron film, and a diffusion with a higher controllability can be effected (Fig. 6D).

The annealing can be effected in a separate apparatus by taking the semiconductor substrate out of the apparatus for introducing impurities as described above.

The boron silicide film which remains on the surface after the annealing step can be removed by etching or oxidation, and a SiO₂ film and the like is formed thereon by CVD for the surface stabilization or the protection of the P⁺ type impurity region. The next step is effected thereafter.

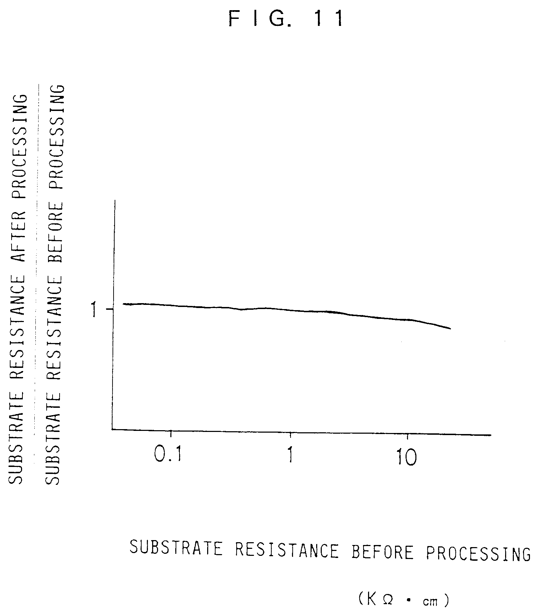

In this method, the substrate resistance is not affected by thermal treatment for forming boron silicide film or boron film and activating a surface, so the substrate resistance before processing is maintained and shallow P⁺ type impurity region is obtained. Fig. 11 shows the change of the substrate resistance before and after processing. In the region where substrate resistance is greater than 1 kΩ before processing, no decrease in substrate resistance after processing is shown. Another method for forming P⁺ type impurity region by thermal diffusion is forming boron compound layer with BBr₃ in a oxide atmosphere and solid phase diffusion by BN.

It is difficult to obtain a substrate with a high resistance, i.e., a substrate having a large elongation for the depletion layer after the processing, by using a silicon substrate having a high substrate resistance.

In such case of employing thermal diffusion, a depletion layer which can be readily elongated can be obtained by effecting ion implantation of BF₂ shallowly at a dose of 5 x 10¹⁵ atoms/cm or lower after the formation of the P⁺ type impurity region, and then subjecting the region to activation by annealing at a relatively low temperature in a range of from 900 to 950°C.

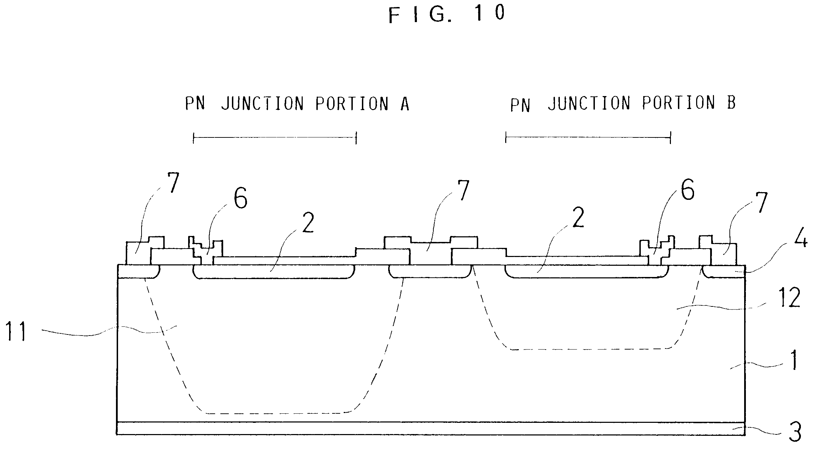

Fig. 10 shows a schematic cross sectional view of an example according to the present invention, in which the conditions of ion implantation are differed within a single substrate during the step of forming a P type impurity region by ion implantation of BF₂ ions. In this manner, the resistivity of the substrate in the peripheral regions of the impurity region is differed as to form a PN junction differing in the elongation of the depletion layer.

Referring to Fig. 10, two PN junction portions A and B, i.e., the light receiving regions of a photodiode, are formed first on a single chip having a resistivity of 4 kΩ · cm.

In this case, BF₂ is introduced by ion implantation into the PN junction portions A and B at a dose of 5 x 10¹⁴ atoms/cm and 5 x 10¹⁵ atoms/cm, respectively.

The elongation of the depletion layer under a same reversed bias potential is shown as a result in Fig. 10. The result for the depletion layer 11 of the PN junction portion A and that for the depletion layer 12 for the PN junction portion B are shown in the figure. It can be seen that the depletion layer 11 of the PN junction portion A having a lower dose can be more easily elongated.

The elongation of the depletion layer can be correlated with the energy of a detectable ionizing radiation. Accordingly, X rays or charged particles differing in energy can be separated and detected by using the above device.

As described in the foregoing, a fabrication process according to a present invention may realise an opto-electronic conversion semiconductor device having a deep depletion layer without being substantially influenced by the process conditions.

## Claims

1. A method of making an opto-electronic conversion semiconductor device, the method characterised by effecting ion implantation using BF₂ at a dose less than 1 x 10¹⁵ atoms/cm on the surface of an N-type semiconductor substrate (1), and forming a P-type impurity region (2) on the surface of said N-type semiconductor substrate (1).

2. A method as claimed in claim 1, wherein said implantation is performed at an energy less than 80 keV.

3. A method as claimed in claim 1 or 2, wherein annealing is effected at a temperature of 900°C or higher.

4. A method as claimed in claim 1, 2 or 3, wherein the method is effected an oxidizing atmosphere at a temperature of 950°C or lower.

5. A method as claimed in claim 1, 2 or 3, wherein, prior to said ion implantation, heat treatment in a non-oxidizing atmosphere is performed at a temperature of 950°C or higher.

6. A method as claimed in claim 1, 2 or 3, wherein said P-type impurity region is formed by effecting thermal diffusion on the surface of said N-type semiconductor substrate.

7. A method as claimed in claim 1, 2 or 3, wherein said P-type impurity region is formed by:
a) removing a natural oxide film from a surface of said N-type semiconductor substrate to expose a chemically active surface;
b) supplying gaseous compound containing boron to the active surface to form a layer of at least one selected from the group consisting of elemental boron and boron compounds; and
c) effecting solid phase diffusion and activation of impurities using said layer of at least one selected from the group consisting of elemental boron and boron compounds as an impurity diffusion source.

8. A method for making an opto-electronic conversion semiconductor device having a diode structure comprising:
effecting ion implantation using BF₂ at a dose less than 1 x 10¹⁵ atoms/cm on the surface of an N-type semiconductor substrate having a resistivity higher than 1 kΩ·cm, and forming a P-type impurity region on the surface of said N-type semiconductor substrate.

9. A method for making an opto-electronic conversion semiconductor device having a diode structure comprising:
effecting ion implantation using BF₂ at a implantation energy less than 80 keV on the surface of an N-type semiconductor substrate having a resistivity higher than 1 kΩ · cm, and forming a P-type impurity region on the surface of said N-type semiconductor substrate.

10. A method for making an opto-electronic conversion semiconductor device having a diode structure comprises: effecting ion implantation using BF₂ on the surface of an N-type semiconductor substrate having a resistivity higher than 1 kΩ · cm, and heating at a temperature higher than 900°C.

11. A method for making an opto-electronic conversion semiconductor device having a diode structure comprising:
effecting ion implantation using BF₂ on the surface of an N-type semiconductor substrate having a resistivity higher than 1 kΩ cm, and heating under an oxidizing atmosphere, at a temperature less than 950°C.

12. A method for making an opto-electronic conversion semiconductor device having a diode structure comprising:
heating at a temperature higher than 950°C in a non-oxidizing atmosphere,
effecting ion implantation using BF₂ on the surface of an N-type semiconductor substrate having a resistivity more than 1 kΩ · cm to form a P-type impurity region.

13. A method for making an opto-electronic conversion semiconductor device having a diode structure comprising:
effecting thermal diffusion on the surface of an N-type semiconductor substrate having a resistivity more than 1 kΩ · cm to form a P-type impurity region; and
a step of implanting ions into said P-type impurity region using BF₂ at a dose less than 1 x 10¹⁵ atoms/cm.

14. A method for making an opto-electronic conversion semiconductor device having a diode structure, formed of a P-type impurity region in N-type semiconductor substrate comprising: a step of making said P-type impurity region
a) removing a natural oxide film from a surface of said N-type semiconductor substrate having a substrate resistance higher than 1 kΩ · cm to expose a chemically active surface;
b) supplying gaseous compound containing boron to the active surface to form a layer of at least one selected from the group consisting of elemental boron and boron compounds; and
c) effecting solid phase diffusion and activation of impurities using said layer of at least one selected from the group consisting of elemental boron and boron compounds as an impurity diffusion source.

15. A method for making an opto-electronic conversion semiconductor device as claimed in any one of the preceding claims, wherein said substrate has a thickness of 200µm or more.

16. A method of making an opto-electronic conversion semiconductor device, comprising a step of forming a P-type impurity region on the surface of an N-type semiconductor substrate by ion implantation of BF₂, characterised in that the resistivity of the region of the substrate (1) in the vicinity of the impurity region (11, 12) is differed by changing the conditions of ion implantation within a single substrate.
